# EUROPEAN PATENT APPLICATION

(11) **EP 4 564 408 A1**
(43) Date of publication of application: **04.06.2025**
(21) Application number: 23213010.4
(22) Date of filing: 29.11.2023
(51) Int. Cl.: H01L 21/67, H01L 21/683

(54) **APPARATUS AND METHOD FOR TRANSFERRING AN ELECTRONIC COMPONENT**

(71) Applicant: Nexperia B.V., 6534 AB Nijmegen (NL)
(72) Inventor: Wesselingh, Jasper, Nijmegen (NL); van der Veen, Gijs, Nijmegen (NL)
(74) Representative: Pjanovic, Ilija

(57) **Abstract**

Aspects of the present disclosure relate to an apparatus for transferring an electronic component or a piece of material using light. Aspects of the present disclosure further relate to a method for transferring an electronic component or a piece of material.

According to an aspect of the disclosure the apparatus comprises a donor stage for holding a donor substrate, an optical source for generating a pulse of collimated light, and a reflection unit comprising a plurality of micro-mirrors of which an orientation relative to the pulse of collimated light can be individually controlled. The micro-mirrors are configured for reflecting the generated pulse of collimated light towards one or more donor positions on a donor substrate body for releasing one or more electronic components or one or more pieces of material among the plurality of electronic components or the plurality of pieces of material at those donor positions, respectively.

## Description

### FIELD

Aspects of the present disclosure relate to an apparatus for transferring an electronic component or a piece of material using light. Aspects of the present disclosure further relate to a method for transferring an electronic component or a piece of material. Aspects of the present disclosure particularly relate to the field of semiconductor technology and more in particular to the field of apparatuses and methods for transferring semiconductor dies, or packaged components comprising semiconductor dies, from a donor substrate to an acceptor substrate and/or to apparatuses and methods for transferring pieces of material, such as solder or other interconnect material, from a donor substrate to an acceptor substrate. Such interconnect material can be used to allow other components, such as semiconductor dies, to be mounted on the acceptor substrate.

### BACKGROUND

Processes in which laser light is used for transferring components or pieces of material are known in the art. A first example is the so-called Laser Induced Forward Transfer, LIFT, process. In this process, laser light is used for locally heating material on a donor substrate such that a predefined quantity of the material is released from the donor substrate and is received on an acceptor substrate.

A second example is the so-called laser die transfer process. In this process, semiconductor dies or other electronic components are fixed to a donor substrate using a dynamic release layer. When the dynamic release layer is subjected to laser light, it will lose its adhesive properties allowing the semiconductor die to become detached from the donor substrate. Once released, the semiconductor die can be received by an acceptor substrate.

In the processes mentioned above, the donor substrate and acceptor substrate are moved to allow semiconductor dies or pieces of material to be released from different positions on the donor substrate and to allow the acceptor substrate to be filled completely. The donor substrate is held by a donor stage and the acceptor substrate by an acceptor stage. Furthermore, a stage driver is used that comprises a donor driver configured to move the donor stage and an acceptor driver configured to move the acceptor stage.

Unfortunately, the donor stage and acceptor stage can be relatively heavy. Displacing these stages therefore requires time and can limit the throughput of the overall process.

### SUMMARY

According to an aspect of the present disclosure, an apparatus for transferring an electronic component or a piece of material using light is provided that addresses the abovementioned problem. To this end, an apparatus is provided that comprises a donor stage for holding a donor substrate. The donor substrate comprises a donor substrate body and a plurality of electronic components or pieces of material to be transferred attached at respective donor positions to the donor substrate body. The apparatus further comprises an optical source for generating a pulse of collimated light. The optical source can for example be a laser, but the present disclosure is not limited thereto. In addition, the apparatus comprises a reflection unit comprising a plurality of micro-mirrors of which an orientation relative to the pulse of collimated light can be individually controlled. The micro-mirrors are configured for reflecting the generated pulse of collimated light towards one or more donor positions for releasing one or more electronic components or one or more pieces of material among the plurality of electronic components or the plurality of pieces of material at those donor positions, respectively.

The Applicant has found that movements of the donor substrate can be reduced by using the individually controllable micro-mirrors of the reflection unit. More in particular, the individually controllable micro-mirrors can be used to reflect the generated pulses of collimated light towards different positions on the donor substrate even if the donor substrate remains stationary relative to the reflection unit.

A ratio between a cross-sectional area of a beam corresponding to the generated pulse of collimated light and an average size of the micro-mirrors is at least 10, more preferably at least 1000. Here it is noted that the cross-sectional area of the beam is computed in a plane perpendicular to the direction in which the pulse is emitted. Additionally, or alternatively, the micro-mirrors can be identical.

The beam associated with the reflected pulse can be convergent. Consequently, the micro-mirrors allow the transfer of electronic components or pieces of material that are smaller than the abovementioned cross-sectional area.

The reflection unit may comprise a mirror substrate on which the micro-mirrors are arranged, wherein each micro-mirror can be configured to be rotatable with respect to the mirror substrate along a first rotational axis and/or a second rotational axis. The mirror substrate is preferably flat. The first and/or second rotational axis can be parallel to the mirror substrate. The micro-mirrors may each correspond to a micro-electromechanical system, MEMS, mirror. Such mirrors are known in the art.

The donor stage can be configured to hold a diced or structured semiconductor wafer, wherein each semiconductor die of the diced or structured wafer is mounted to a substrate, for example in the form of a foil or film, using a photosensitive or heat-sensitive adhesive layer. Alternatively, the donor stage can be configured to hold a component carrier on which the plurality of electronic components is mounted using a photosensitive or heat-sensitive adhesive layer, wherein the electronic components are components from the group consisting of semiconductors, LEDs, and passives. When light from the optical source is focused on the abovementioned photosensitive or heat-sensitive adhesive layer, the layer loses its adhesive properties thereby causing the release of the relevant electronic component or semiconductor die.

The donor stage can also be configured to hold a material carrier on or in which the pieces of material are arranged, wherein the pieces of material are configured to locally ablate or melt when at least partially absorbing a reflected pulse of light for the purpose of being released from the material carrier. The released material can for example comprise adhesives, solder paste, flux, conductive epoxy, and/or conductive ink.

The apparatus may further comprise an acceptor stage for holding an acceptor substrate. The acceptor substrate may comprise an acceptor substrate body and a plurality of placement positions on the acceptor substrate body on which the electronic components or pieces of material are to be arranged. In some embodiments, the released electronic components or pieces of material fall towards the acceptor substrate body. Additionally, or alternatively, the released electronic components or pieces of material can be propelled towards the acceptor substrate body as a consequence of the energy that is released when at least partially absorbing the energy associated with the generated pulse.

The apparatus may further comprise a micro-mirror driver for individually controlling the orientation of the micro-mirrors, a stage driver for controlling the mutual position of the donor stage and the acceptor stage and for controlling the mutual position of the reflection unit and the donor stage, and a controller for controlling the optical source, the micro-mirror driver, and the stage driver. For example, the controller may control the optical source to generate a pulse once the micro-mirrors have been oriented such that the generated pulse is reflected towards one or more donor positions. To this end, the controller may be configured to control the stage driver to bring the donor substrate and reflection unit in a suitable mutual position. Similarly, the controller may be configured to control the stage driver to bring the donor substrate and acceptor substrate in a suitable mutual position such that the released electronic component or piece of material is received at a desired placement position on the acceptor substrate body.

The controller can be configured for controlling the optical source, the micro-mirror driver, and the stage driver to repeatedly generate a pulse of collimated light for repeatedly releasing one or more electronic components or one or more pieces of material and arranging the released one or more electronic components or one or more pieces of material on respective placement positions on the acceptor substrate body. The controller can further be configured to mutually position the donor substrate and acceptor substrate and/or to mutually position the donor substrate and the reflection unit prior to generating a next pulse of collimated light. For example, the controller may be configured to change the orientation of the micro-mirrors using the micro-mirror driver and to move the acceptor substrate relative to the donor substrate after having released an electronic component or piece of material while keeping the donor substrate and reflection unit stationary. In this approach, an electronic component or piece of material to be released next is selected by changing the orientation of the micro-mirrors while keeping the donor substrate stationary relative to the reflection unit. The Applicant has found that such selection can be performed faster than selection based on moving the donor substrate relative to the reflection unit. Accordingly, using the micro-mirrors allows a higher throughput to be obtained.

The reflection unit need not be stationary. For example, the optical source can be configured for emitting the pulse of collimated light in a first direction, wherein the stage driver comprises a reflection unit driver for moving the reflection unit back and forth along the first direction. The Applicant has found that the reflection unit is typically much lighter than a donor stage. Consequently, an electronic component or piece of material to be released next can be selected more quickly by moving the reflection unit compared to moving the donor substrate as is common with prior art systems.

The donor stage can be configured for holding a flat donor substrate and the acceptor stage can be configured for holding a flat acceptor substrate. In this case, the stage driver may comprise a donor driver configured to move the donor stage in a first plane or along a first line, and/or an acceptor driver configured to move the acceptor stage in a second plane or along a second line, wherein the first plane or first line is parallel to the second plane and/or wherein the second plane or second line is parallel to the first plane.

The table below illustrates possible embodiments that differ in the degrees of freedom associated with the movement of the reflection unit, donor substrate and acceptor substrate. Here, it is noted that the pulses are emitted in the y-direction, which is perpendicular to the x-direction.

| Reflection unit | Donor substrate | Acceptor substrate |
|---|---|---|
| y-direction | x-direction | x-direction + y-direction |
| stationary | x-direction + y-direction | x-direction + y-direction |
| y-direction | x-direction + y-direction | x-direction |

The donor stage can be configured for holding a curved donor substrate. For example, the donor stage may comprise a cylindrical body on which the curved donor substrate can be arranged. The stage driver can be configured for translating the donor stage along a third line and for rotating the donor stage about a rotational axis that is parallel to the third line. When using a cylindrical body, the third line may correspond to the axial axis of the cylindrical body. The curved donor substrate can be used in combination with flat acceptor substrates. An advantage of using curved substrates is the speed at which a different electronic component or piece of material to be released next can be selected.

The reflection unit may comprise a plurality of subsets of micro-mirrors, each subset being configured for reflecting the generated pulse to a respective donor position. In this manner, a single generated pulse can be reflected towards multiple donor positions. Furthermore, the controller can be configured for controlling each subset of micro-mirrors for reflecting the generated pulse to a respective donor position by determining settings of the micro-mirrors in dependence of said respective donor position and controlling said subset of micro-mirrors using the determined settings.

According to a further aspect of the present disclosure, a method for transferring an electronic component or a piece of material is provided that comprises holding a donor substrate that comprises a donor substrate body and a plurality of electronic components or pieces of material to be transferred attached at respective donor positions to the donor substrate body, generating a pulse of collimated light, individually controlling a plurality of micro-mirrors of which an orientation relative to the pulse of collimated light can be individually controlled such that the generated pulse of collimated light is reflected towards one or more donor positions for releasing one or more electronic components or one or more pieces of material among the plurality of electronic components or the plurality of pieces of material at those donor positions, respectively. The method may optionally comprise holding an acceptor substrate that comprises an acceptor substrate body and a plurality of placement positions on the acceptor substrate body on which the electronic components or pieces of materials are to be arranged and arranging the released one or more electronic components or one or more pieces of material at respective placement positions on the acceptor substrate body.

The method may further comprise repeatedly generating a pulse of collimated light for repeatedly releasing one or more electronic components or one or more pieces of material in accordance with the above, and prior to generating a next pulse of collimate light, mutually positioning the donor substrate and acceptor substrate and/or mutually positioning the donor substrate and the reflection unit.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates an embodiment of an apparatus for transferring an electronic component or a piece of material in accordance with the present disclosure;
Figure 2 illustrates a reflection unit used in the apparatus of figure 1;
Figure 3 schematically illustrates examples of a donor substrate and acceptor substrate in accordance with the present disclosure;
Figure 4 illustrates detailed examples of a donor substrate in accordance with the present disclosure;
Figure 5 illustrates reflecting the generated pulse towards multiple donor positions;
Figure 6 illustrates releasing different components without moving the donor substate;
Figure 7 illustrates a method for transferring an electronic component or a piece of material in accordance with the present disclosure.

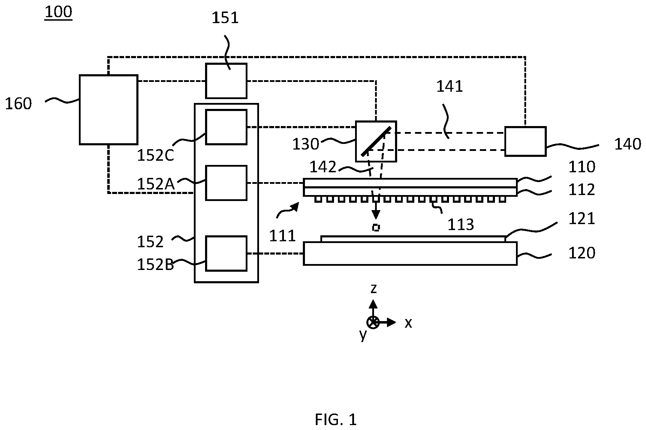

In figure 1, an apparatus 100 for transferring an electronic component or a piece of material in accordance with an aspect of the present disclosure is shown that comprises a donor stage 110 for holding a donor substrate 111, and an acceptor stage 120 for holding an acceptor substrate 121. Apparatus 100 further comprises a reflection unit 130 that comprises a micro-mirror unit that includes a plurality of micro-mirrors. Apparatus 100 also comprises an optical source 140, such as a laser, that generates pulses of collimated light.

Donor substrate 111 comprises a donor substrate body 112 and a plurality of electronic components or pieces of material 113 to be transferred that are attached at respective donor positions 112A to donor substrate body 112. Similarly, acceptor substrate 121 comprises an acceptor substrate body 122 and a plurality of placement positions 122A on acceptor substrate body 122 on which electronic components or pieces of material 113 are to be arranged.

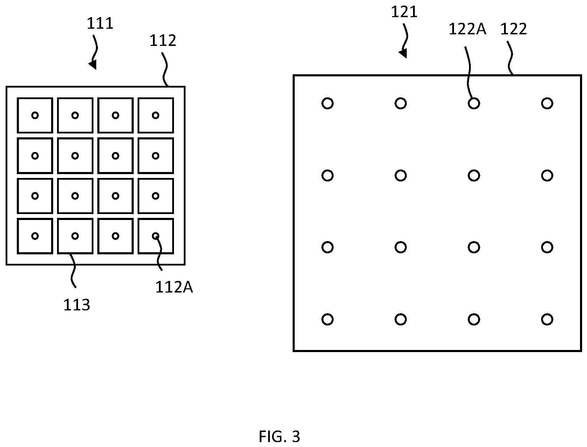

Figure 3 presents a top view of donor substrate 111 and acceptor substrate 121 illustrating donor positions 112A and placement positions 122A, respectively. It should be noted that the pitch of donor positions 112A is generally smaller than the pitch of placement positions 112A.

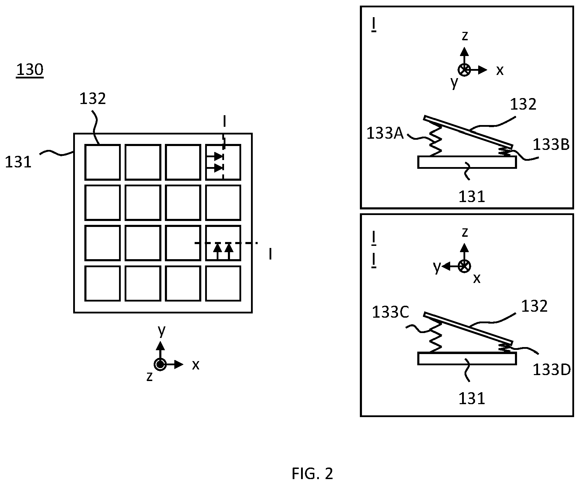

Figure 2 illustrates reflection unit 130 in more detail. As shown, reflection unit 130 comprises a mirror substrate 131 on which micro-mirrors 132 are arranged. Cross-sectional views along lines I and II, shown on the right in figure 2, illustrate how micro-mirrors 132 are mounted to mirror substate 131 using piezoelectric members 133A, 133B, 133C, 133D. Instead of a piezoelectric member, a combination of a silicon flexure and an electrostatic comb drive can be used for moving a micro-mirror 132. By controlling a voltage applied to members 133A, 133B, 133C, 133D, a length of these members can be controlled. By appropriately controlling the voltages applied to members 133A, 133B, 133C, 133D, using a micro-mirror driver 151, micro-mirror 132 can be rotated or pivoted relative to mirror substrate 131. Such control is possible for each micro-mirror 132 individually. Moreover, the rotation of micro-mirrors 132 corresponds to a rotation about a first rotational axis that is parallel to the y-direction in figure 2, and to a rotation about a second rotational axis that is parallel to the x-direction in figure 2.

It should be noted that the micro-electromechanical systems, MEMS, mirror shown in figure 2 is a possible embodiment of a micro-mirror for reflection unit 130. Other embodiments for micro-mirrors of which the orientation can be individually controlled are not excluded.

Now referring again to figure 1, apparatus 100 further comprises a stage driver 152 that is configured for controlling the mutual position of donor stage 110 and acceptor stage 120 and for controlling the mutual position of reflection unit 130 and donor stage 110. To that end, stage driver 152 comprises a donor driver 152A configured to move donor stage 110 in a first plane or along a first line, and an acceptor driver 152B configured to move acceptor stage 120 in a second plane or along a second line, wherein the first plane or first line is parallel to the second plane and/or wherein the second plane or second line is parallel to the first plane. For example, donor driver 152A is able to move donor stage 110 in the x-y plane in figure 1, and acceptor driver 152B is able to move acceptor stage 120 in the x-y plane in figure 1. However, the present disclosure is not limited thereto.

In figure 1, optical source 140 is configured to emit pulses of collimated light in the (minus) x-direction. Typically, optical source 140 is mounted stationary relative to a supporting frame of apparatus 100. Stage driver 152 may comprise a reflection unit driver 152C for moving reflection unit 130 back and forth along the x-direction.

Apparatus 100 may further comprise a controller 160 for controlling optical source 140, micro-mirror driver 151, and stage driver 152.

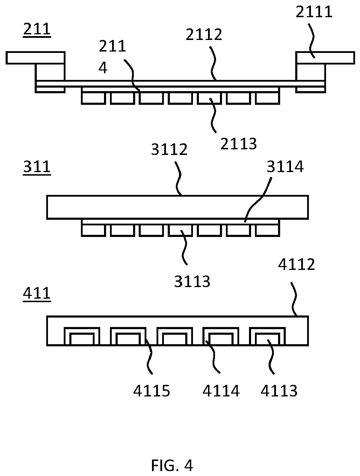

Figures 4 illustrates detailed examples of a donor substrate in accordance with the present disclosure. The top figure illustrates a donor substrate 211 that comprises a film-frame carrier, FFC, 2111 having a foil or film 2112 onto which a plurality of semiconductor dies 2113 are mounted using an adhesive layer 2114. Semiconductor dies 2113 may originate from a diced or structured semiconductor wafer. FFC 2111 with foil or film 2112 and adhesive layer 2114 may collectively be referred to as a donor substrate body.

The figure in the center illustrates a donor substrate 311 that comprises a component carrier 3112, for example made of glass or plastic, on which a plurality of electronic components 3113, such as semiconductor dies, LEDs, or passives, is mounted using a release layer 3114. Component carrier 3112 and release layer 3114 may collectively be referred to as a donor substrate body.

The bottom figure illustrates a donor substrate 411 that comprises a material carrier 4112, for example made of glass, quartz or plastic having cavities 4115 in which pieces of material 4113, such as solder paste, flux or epoxy, are arranged. An optional isolation layer 4114 may be provided to ensure thermal insulation between material carrier 4112 and the pieces of material 4113. Material carrier 4112 and isolation layer 4114 may collectively referred to as a donor substate body. Material carrier 4112 can for example be made of glass, Polyethylene Terephthalate, PET, Polyimide, PI, or Polyvinylchloride, PVC. Isolation layer 4114 may comprise a layer of glass, siloxane or ceramic, whereas pieces of material 4113 may comprise pieces of solder paste, flux, epoxy, conductive adhesive or conductive ink.

In the examples above, release layer 2114, 3114 is a photosensitive or heat-sensitive adhesive layer. When illuminating this layer with light of sufficient intensity and appropriate wavelength, it will lose its adhesive properties thereby causing semiconductor dies 2113 or components 3113 to be become detached. With respect to the bottom figure, when pieces of material 4113 are illuminated with light of sufficient intensity and appropriate wavelength it will locally ablate or melt causing the pieces of material 4113 to be released.

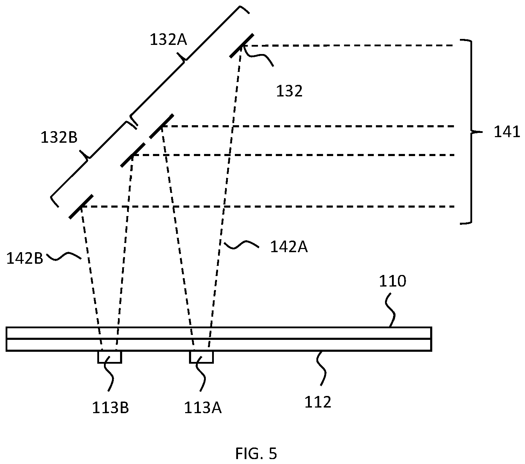

Figure 5 illustrates reflecting the generated pulse towards multiple donor positions. In this embodiment, the reflection unit comprises two subsets 132A, 132B of micro-mirrors 132 that are mounted on a single mirror substate 131 in a manner similar to figure 2.

In figure 1, optical source 140 emits a beam 141 towards reflection unit 130 that is reflected as a single convergent beam 142 focused towards a single donor position. In figure 5 however, each subset of micro-mirrors 132 generates a separate reflected beam 142A, 142B that is focused toward separate donor positions at which different electronic components 113A, 113B are provided. Using this approach, two components 113A, 113B can be released substantially simultaneously provided that the distance between these components corresponds to the distance between the intended placement positions on the acceptor substrate body.

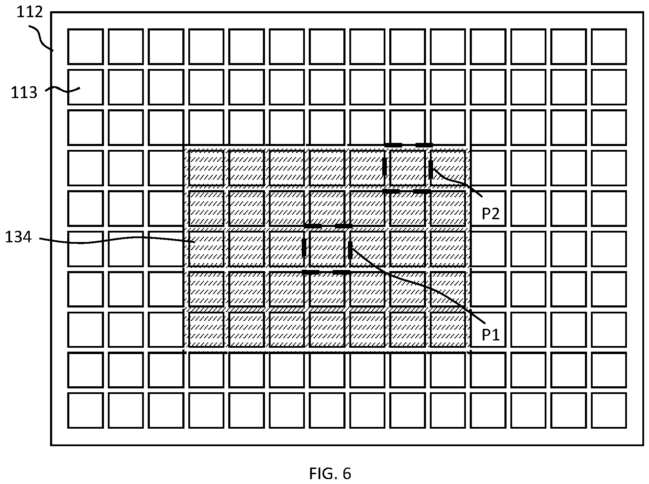

Figure 6 illustrates a donor substrate body 112 on which a plurality of components 113 are arranged. In the same figure, a rectangle 134 is shown that indicates to which components 113 on donor substrate body 112 a pulse may be reflected by reflection unit 130. As shown, rectangle 134 covers a plurality of components 113. Consequently, after releasing a component 113 that is situated inside rectangle 134 and that is marked by dashed rectangle P1, a next component 113 in rectangle 134 and marked by rectangle P2 can be selected for release. Selecting this next component does not require movement of donor substrate 111. Instead, a next component 113 can be selected by appropriately controlling the orientation of micro-mirrors 132. As the mass associated with micro-mirrors 132 is much smaller than the mass associated with donor stage 110 and donor substrate 111, selection of this next component can be realized more quickly.

Stage driver 152 can be used to change the mutual position of donor substrate body 112 and rectangle 134. In addition, when selecting a next component to be released without moving donor substrate 111, it needs to be assured that the next component will be arranged on an appropriate placement position. To that end, it may be required to have stage driver 152 move acceptor stage 120. In an embodiment, an optimization may be used to determine the component to be released next without moving donor stage 110 that would require the smallest distance to be traversed by acceptor stage 120. Further optimizations are possible that minimize the time it takes for completely filling acceptor substrate 121.

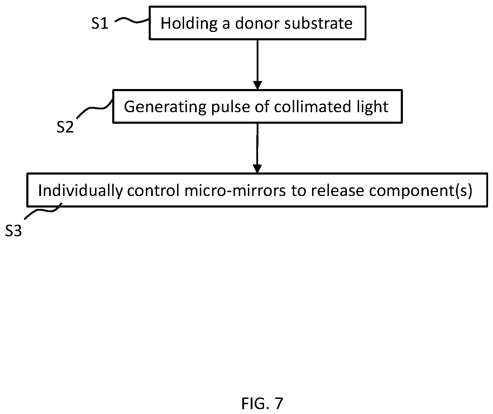

Figure 7 illustrates a method for transferring an electronic component or a piece of material, comprising the steps of holding S1 a donor substrate that comprises a donor substrate body and a plurality of electronic components or pieces of material to be transferred attached at respective donor positions to the donor substrate body, generating S2 a pulse of collimated light, and individually controlling S3 a plurality of micro-mirrors of which an orientation relative to the pulse of collimated light can be individually controlled such that the generated pulse of collimated light is reflected towards one or more donor positions for releasing one or more electronic components or one or more pieces of material among the plurality of electronic components or the plurality of pieces of material at those donor positions, respectively.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. An apparatus (100) for transferring an electronic component (113; 2113; 3113) or a piece (4113) of material using light, comprising:
a donor stage (110) for holding a donor substrate (111), said donor substrate comprising a donor substrate body (112) and a plurality of electronic components or pieces of material to be transferred attached at respective donor positions (112A) to the donor substrate body;
an optical source (140) for generating a pulse of collimated light;
a reflection unit (130) comprising a plurality of micro-mirrors (132) of which an orientation relative to the pulse of collimated light can be individually controlled, wherein the micro-mirrors are configured for reflecting the generated pulse of collimated light towards one or more donor positions for releasing one or more electronic components or one or more pieces of material among the plurality of electronic components or the plurality of pieces of material at those donor positions, respectively.

2. The apparatus according to claim 1, wherein a ratio between a cross-sectional area of a beam corresponding to the generated pulse of collimated light and an average size of the micro-mirrors is at least 10, more preferably at least 1000, and wherein the micro-mirrors are preferably identical.

3. The apparatus according to claim 1 or 2, wherein the beam associated with the reflected pulse is convergent.

4. The apparatus according to any of the previous claims, wherein the reflection unit comprises a mirror substrate (131) on which the micro-mirrors are arranged, wherein each micro-mirror is configured to be rotatable with respect to the mirror substrate along a first rotational axis and/or a second rotational axis, wherein the mirror substrate is preferably flat and wherein, more preferably, the first and/or second rotational axis are parallel to the mirror substrate.

5. The apparatus according to any of the previous claims, wherein:
the donor stage is configured to hold a diced or structured semiconductor wafer, wherein each semiconductor die (2113) of the diced or structured wafer is mounted to a substrate, for example in the form of a foil or film (2112), using a photosensitive or heat-sensitive adhesive layer (2114); or
the donor stage is configured to hold a component carrier (3112) on which the plurality of electronic components (3113) is mounted using a photosensitive or heat-sensitive adhesive layer (3114), wherein the electronic components are components from the group consisting of semiconductor dies, LEDs, and passives; or
the donor stage is configured to hold a material carrier (4112) on or in which the pieces of material (4113) are arranged, wherein the pieces of material are configured to locally ablate or melt when at least partially absorbing a reflected pulse of light for the purpose of being released from the material carrier, wherein the pieces of material are pieces of solder paste, flux, adhesive, conductive epoxy, and/or conductive ink.

6. The apparatus according to any of the previous claims, further comprising an acceptor stage (120) for holding an acceptor substrate (121), said acceptor substrate comprising an acceptor substrate body (122) and a plurality of placement positions (122A) on the acceptor substrate body on which the electronic components or pieces of material are to be arranged.

7. The apparatus according to claim 6, further comprising;
a micro-mirror driver (151) for individually controlling the orientation of the micro-mirrors;
a stage driver (152) for controlling the mutual position of the donor stage and the acceptor stage and for controlling the mutual position of the reflection unit and the donor stage; and
a controller (160) for controlling the optical source, the micro-mirror driver, and the stage driver.

8. The apparatus according to claim 7, wherein the controller is configured for controlling the optical source, the micro-mirror driver, and the stage driver to:
repeatedly generate a pulse of collimated light for repeatedly releasing one or more electronic components or one or more pieces of material and arranging the released one or more electronic components or one or more pieces of material on respective placement positions on the acceptor substrate body; and
prior to generating a next pulse of collimated light, mutually position the donor substrate and acceptor substrate and/or mutually position the donor substrate and the reflection unit.

9. The apparatus according to any of the claims 7-8, wherein the optical source is configured for emitting the pulse of collimated light in a first direction, wherein the stage driver comprises a reflection unit driver (152C) for moving the reflection unit back and forth along the first direction.

10. The apparatus according to any of the claims 7-9, wherein the donor stage is configured for holding a flat donor substrate and wherein the acceptor stage is configured for holding a flat acceptor substrate;
wherein the stage driver comprises a donor driver (152A) configured to move the donor stage in a first plane or along a first line; and
wherein the stage driver comprises an acceptor driver (152B) configured to move the acceptor stage in a second plane or along a second line, wherein the first plane or first line is parallel to the second plane and/or wherein the second plane or second line is parallel to the first plane.

11. The apparatus according to any of the claims 7-10, wherein the donor stage is configured for holding a curved donor substrate, and wherein the stage driver is configured for translating the donor stage along a third line and for rotating the donor stage about a rotational axis that is parallel to the third line.

12. The apparatus according to any of the previous claims, wherein the reflection unit comprises a plurality of subsets (132A, 132B) of micro-mirrors, each subset being configured for reflecting the generated pulse to a respective donor position (113A, 113B).

13. The apparatus according to claim 12 in so far as depending on claim 7, wherein the controller is configured for controlling each subset of micro-mirrors for reflecting the generated pulse to a respective donor position by:
determining settings of the micro-mirrors of each subset of micro-mirrors in dependence of said respective donor position; and
controlling said subset of micro-mirrors using the determined settings.

14. A method for transferring an electronic component or a piece of material, comprising:
holding a donor substrate that comprises a donor substrate body and a plurality of electronic components or pieces of material to be transferred attached at respective donor positions to the donor substrate body;
generating a pulse of collimated light;
individually controlling a plurality of micro-mirrors of which an orientation relative to the pulse of collimated light can be individually controlled such that the generated pulse of collimated light is reflected towards one or more donor positions for releasing one or more electronic components or one or more pieces of material among the plurality of electronic components or the plurality of pieces of material at those donor positions, respectively;
the method optionally comprising:
holding an acceptor substrate that comprises an acceptor substrate body and a plurality of placement positions on the acceptor substrate body on which the electronic components or pieces of material are to be arranged; and
arranging the released one or more electronic components or one or more pieces of material at respective placement positions on the acceptor substrate body.

15. The method according to claim 14, further comprising:
repeatedly generating a pulse of collimated light for repeatedly releasing one or more electronic components or one or more pieces of material in accordance with claim 14; and
prior to generating a next pulse of collimated light, mutually positioning the donor substrate and acceptor substrate and/or mutually positioning the donor substrate and the reflection unit.
